# EUROPÄISCHE PATENTSCHRIFT

(11) **EP 1 005 963 B1**
(45) Veröffentlichungstag und Bekanntmachung des Hinweises auf die Patenterteilung: **13.04.2005**
(21) Anmeldenummer: 99112221.9
(22) Anmeldetag: 25.06.1999
(51) Int. Cl.: B26F 1/04, B26F 1/02, B23D 35/00, B26D 7/26, H05K 3/00

(54) **Stanzeinrichtung mit wechselbaren Stempeln**
Punching device comprising removable stamps
Dispositif de poinçonnage ayant des poinçons remplaçables

(30) Priorität: 02.12.1998 DE 19855578
(43) Veröffentlichungstag der Anmeldung: 07.06.2000
(73) Patentinhaber: Groz-Beckert Kommanditgesellschaft, 72458 Albstadt (DE)
(72) Erfinder: Beerhalter, Siegfried, 73529 Schwäbisch Gmünd (DE)
(74) Vertreter: Patentanwälte Rüger, Barthelt & Abel

(56) Entgegenhaltungen:
- EP-A- 0 423 052
- EP-A- 0 583 537
- US-A- 4 685 613
- US-A- 5 076 127
- US-A- 5 090 284
- US-A- 5 214 991
- US-A- 5 233 895

## Beschreibung

Die Erfindung betrifft eine Stanzeinrichtung, die insbesondere zum Einbringen von Löchern in ungebrannte Keramiksubstrate, sogenannte Green Sheets, vorgesehen ist.

Bspw. bei der Herstellung von Mehrschicht-Keramiksubstraten als Träger und zur elektrischen Kontaktierung von elektrischen und elektronischen Bauelementen ist es häufig erforderlich, in flächenhafte, ungebrannte Keramikschichten oder -Rohlinge, sogenannte Green Sheets, vorgegebene Lochmuster einzubringen. Die Löcher, die bspw. der Durchkontaktierung von aufgedruckten Leiterbahnen dienen können, werden durch Lochstempel erzeugt, die, um die erforderliche Bearbeitungsgenauigkeit an den Green Sheets zu erreichen, selbst bis auf wenige Mikrometer Toleranz genau gefertigt sind.

Aus der US-PS 5.233.895 ist eine Stanzeinrichtung zum Stanzen von Green Sheets bekannt. Zu dieser gehört ein im Wesentlichen ortsfester Tisch, auf den das Green Sheet aufgelegt und auf dem es bedarfsweise verschoben wird. Oberhalb des Tischs ist ein Grund- oder Trägerkörper angeordnet, der eine Führungseinrichtung für einen axial beweglichen Stempel aufweist. Dessen als Stanzwerkzeug dienendes freies Ende ist in einer Durchgangsöffnung einer ansonsten becherartig ausgebildeten Führung axial verschiebbar gelagert. Dem Stempel gegenüberliegend ist in dem Tisch eine Öffnung vorgesehen, in die der Stempel mit seinem Ende hineinstoßen kann.

Der Stempel ist an seinem oberen Ende mit einer Zylinderspule verbunden, die in dem ringförmigen Luftspalt einer Permanentmagnetanordnung angeordnet ist, in dem ein radiales Magnetfeld ausgebildet ist. Eine elektrische Erregung der Spule führt somit zu einer Axialbewegung der Spule und des Stempels, so dass dieser aus einer zurückgezogenen in eine vorgeschobene Position und zurück überführbar ist.

Stempel unterliegen durch die wiederholt ablaufenden Stanzvorgänge einem Verschleiß, der dazu führen kann, dass einzelne Stempel oder alle Stempel auszuwechseln sind.

Aus der US-PS 5.024.127 ist es dazu bekannt, die elektrische Antriebseinrichtung und das von dem Stempel gebildete Stanzwerkzeug über eine lösbare Kupplungseinrichtung miteinander zu verbinden. Der Stempel ist in einer Führungseinrichtung axial verschiebbar geführt. Die Antriebseinrichtung weist einen fluchtend zu dem Stempel angeordneten Schaft auf, der durch einen mit einem Ende des Schafts verbundenen elektrischen Antrieb bewegbar ist. Das dem Stempel zugewandte und von dem Antrieb abliegende Ende des Schafts trägt ein Kupplungselement, das einen an dem Stempel vorgesehenen Kopf aufnimmt. Dazu legt das Kupplungselement einen Aufnahmeraum fest, der in Axialrichtung durch eine Anlagefläche für das stirnseitige Ende des Stempels und eine zweite, durch eine Gabel definierte geteilte Fläche begrenzt ist, die als Auflagefläche für den in der Nähe des Endes des Stempels vorgesehenen Kopf dient. Sind die Antriebseinrichtung, der Schaft und das Kupplungselement von dem Stempel getrennt, ist dessen Position nicht festgelegt. Er kann damit, bspw. unter der Wirkung seines Eigengewichts, in eine Position gelangen, die mit seiner Auskuppelposition nicht übereinstimmt. Dies kann die Handhabung erschweren und insbesondere dann zu Problemen führen, wenn Stempel von Zeit zu Zeit, bspw. aus Verschleißgründen, zu wechseln sind.

Aus der US-PS 5090284 ist eine Einrichtung zum Stanzen von Green Sheets bekannt, die eine Anzahl von axial beweglichen Stanzstempeln aufweist. Alle Stanzstempel sind durch individuell zugeordnete Druckfedern in einer oberen Ruheposition gehalten. Eine Antriebseinheit ist dazu vorgesehen, die Stempel bedarfsweise axial nach unten zu drücken, um einen Stanzvorgang auszuführen. Zur Verbindung zwischen einzelnen Antrieben der Antriebseinheit und den Stempeln sind ein- und auskuppelbare Kupplungseinrichtungen vorgesehen.

Davon ausgehend ist es Aufgabe der Erfindung, eine Stanzeinrichtung zu schaffen, deren Handhabung insbesondere beim Stempelwechsel verbessert ist.

Diese Aufgabe wird von einer Stanzeinrichtung mit den Merkmalen des Anspruchs 1 gelöst.

Die erfindungsgemäße Stanzeinrichtung weist einen Grundkörper auf, an dem ein oder mehrere Stempel zwischen einer vorgeschobenen und einer zurückgezogenen Position (Stanzposition und Rückzugsposition) axial verschiebbar gelagert sind. Das Verschieben der Stempel erfolgt durch eine Antriebseinheit, zu der vorzugsweise für jeden Stempel eine gesonderte Antriebseinrichtung gehört. Die Antriebseinrichtungen sind von einer Steuereinheit so angesteuert, dass die Stempel gezielt kurzzeitig vorgeschoben, d.h. in Stanzposition überführt werden können, um dadurch einen Stanzvorgang durchzuführen. Die Übertragung der Axialbewegung von der jeweiligen Antriebseinrichtung auf den zugeordneten Stempel erfolgt über eine Kupplungseinrichtung, die bedarfsweise lösbar ist. Die Kupplungseinrichtung erbringt in Axialrichtung eine feste Verbindung zwischen der Antriebseinrichtung und dem jeweiligen Stempel und ermöglicht somit die axiale Bewegungsübertragung. Damit legt die Antriebseinrichtung die Axialposition des Stempels fest. Wird die Antriebseinrichtung jedoch von dem zugeordneten Stempel getrennt, ist dessen Axialposition nicht länger von der Antriebseinrichtung erzwungen. Hier dient nun die durch die Kopfplatte gebildete Aufnahmeeinrichtung dazu, den Stempel in einer gewünschten Axialposition zu halten. Dies bspw., um zu verhindern, dass der Stempel unbeabsichtigt in seine vorgeschobene Position gelangt, in der sein freies, als Stanzwerkzeug dienendes Ende aus der entsprechenden Führung und dem Grundköper herausragen würde und somit der Beschädigungsgefahr ausgesetzt wäre. Die Aufnahmeeinrichtung legt die Position des jeweiligen Stempels wenigstens insoweit fest, dass dessen Bewegungsbereich in wenigstens einer Richtung deutlich eingeschränkt ist. Die entgegengesetzte Richtung kann jedoch frei sein. Dies hat bspw. den Vorteil, dass die Stempel bei abgenommener Abtriebseinheit aus ihren Führungen herausnehmbar und durch andere Stempel ersetzbar sind.

Die Aufnahmeeinrichtung die die Stempel übernimmt, solange die Antriebseinheit abgekoppelt ist, hält die Stempel in einer vorgegebenen Position auch beim Wiederansetzen oder Ankuppeln der Antriebseinheit, wodurch dieser Vorgang besonders einfach durchführbar ist. Es ergibt sich dadurch eine deutlich erleichterte Handhabung.

An dem Grundköper bzw. einer dazu vorgesehenen, an dem Grundkörper gelagerten Führungseinrichtung sind vorzugsweise mehrere Stempel, die untereinander gleich ausgebildet sind, unabhängig voneinander und parallel zueinander axial verschiebbar gelagert, sofern sie von der Aufnahmeeinrichtung freigegeben sind. Sind die Stempel von der Aufnahmeeinrichtung aufgenommen, sind sie alle in einer festgelegten Position, vorzugsweise der Rückzugsposition gehalten.

Bei einer zweckmäßigen Ausführungsform sind die Stempel jeweils durch einen zylindrischen Schaft gebildet, an den sich als Stanzwerkzeug ein zylindrischer Stanzabschnitt anschließt, dessen Durchmesser deutlich geringer ist als der Durchmesser des Schafts. Der Schaft ist in einer Führung, bspw. einer entsprechenden Führungsbuchse gelagert. Der Stanzabschnitt durchragt eine Öffnung eines bspw. becherförmig ausgebildeten Führungs- oder Abstreifelements. In zurückgezogenem Zustand ragt der Stanzabschnitt nicht aus dem Führungs- und Abstreifelement heraus, jedoch steht das stirnseitige Ende des Stanzabschnitts innerhalb einer in dem Führungsund Abstreifelement vorgesehenen Öffnung. Der Schaft und der Stanzabschnitt sind vorzugsweise koaxial zueinander ausgerichtet. Die Führungsbuchse führt den Schaft beim Einführen eines Stempels mit einer solchen Genauigkeit, dass der Stanzabschnitt ohne anzustoßen in die Öffnung des Führungs- und Abstreifelements einfindet.

An seinem von dem Stanzelement abliegenden Ende weist der Stempel vorzugsweise einen Kopf auf, der mit dem ihm zugeordneten Kupplungselement die Kupplungseinrichtung zum Ankuppeln des Stempels an die Antriebseinrichtung bildet. Das Kupplungselement kuppelt den Stempel formschlüssig. Dazu weist es einen seitlich offenen Aufnahmeraum für den Kopf des Stempels auf. Der Aufnahmeraum ist von zwei einander gegenüberliegenden Flächen begrenzt, zwischen die der Kopf des Stempels mit geringem Spiel oder nahezu spielfrei passt. Zum Abkuppeln der Antriebseinrichtung von dem Stempel wird diese seitlich bewegt, so dass der Kopf des Stempels seitlich aus dem Aufnahmeraum herausfindet. Die Kupplungselemente aller Antriebseinrichtungen oder wenigstens einer Gruppe der Antriebseinrichtungen sind gleich orientiert, so dass das Ein- und Auskuppeln der Kupplungseinrichtungen durch ein seitliches Verschieben der gesamten Antriebseinheit oder einer bestimmten Gruppe von Antriebseinrichtungen erfolgt. Damit wird es bspw. möglich, eine Antriebseinheit von der Stanzeinrichtung abzunehmen, wonach die von der betreffenden Antriebseinheit individuell betätigten Stempel einzeln zugänglich sind.

Als Aufnahmeeinrichtung für die Stempel bzw. deren Köpfe dient eine Kopfplatte, die zwischen der Antriebseinheit und den Führungseinrichtungen für die Stempel angeordnet ist. Die Führungseinrichtungen sind an dem Grundkörper vorgesehen und bspw. durch Führungsbuchsen gebildet. Die Kopfplatte ist somit in Nachbarschaft zu dem auf die jeweilige Antriebseinrichtung hin weisenden Ende des jeweiligen Stempels und somit in Nachbarschaft zu der Kupplungseinrichtung angeordnet. Durch diese Position kann die Kopfplatte die Stempel oder deren Köpfe übernehmen, wenn diese von den Kupplungselementen freigegeben werden. Wird die Antriebseinheit von den Stempeln abgekuppelt, werden die Stempel somit von der Kopfplatte aufgenommen, so dass sie nicht unkontrolliert in eine unerwünschte Position, bspw. ihre vorgeschobene Position (Stanzposition) gelangen können.

Zur Aufnahme der Köpfe der Stempel dient an der Kopfplatte vorzugsweise für jeden Stempel ein gesonderter Auflagebereich, der unter den Stempelkopf geschoben wird, bevor dieser aus dem Kupplungselement ganz ausgetreten ist. Dazu ist es vorteilhaft, wenn der an der Kopfplatte ausgebildete Auflageflächenbereich auf einer Höhe mit der entsprechenden, an dem Kupplungselement ausgebildeten Auflagefläche, d.h. in einer gemeinsamen Ebene mit dieser liegt, wenn das Kupplungselement in zurückgezogener Position steht.

Um das Kupplungselement beim Auskuppeln zwangsweise in dieser Position zu halten, weist das Kupplungselement vorteilhafterweise eine Stirnfläche auf, die, wenn sich das Kupplungselement in zurückgezogener Position befindet, auf einer Höhe mit einer an der Unterseite der Kopfplatte vorgesehenen Lagerfläche liegt. Dadurch findet das Kupplungselement beim Auskuppeln eine feste Anlage, bspw. an dem Grundkörper oder an einem anderweitigen Widerlager, und ist somit zwangsweise in einer Position gehalten, in der die Übergabe des bis dahin in dem Aufnahmeraum gehaltenen Kopfs des Stempels an die Kopfplatte ermöglicht ist.

An dem Kupplungselement kann im Anschluss an die Stirnfläche eine Positionierfläche ausgebildet sein, die dazu dient, das Kupplungselement in eine Wechselposition zu überführen, in der der Kopf des Stempels an die Kopfplatte übergeben werden kann. Diese Wechselposition ist vorzugsweise die Position, die die rückgezogene Position des Stempels festlegt. Die Positionierfläche kann bspw. durch eine schräge Anlauffläche gebildet sein. Dieser kann eine ortsfeste, bspw. an dem Grundkörper ausgebildete Kante als Widerlager zugeordnet sein.

Weitere Einzelheiten vorteilhafter Ausführungsformen der Erfindung ergeben sich aus der Zeichnung, der Beschreibung oder Unteransprüchen.

In der Zeichnung ist ein Ausführungsbeispiel der Erfindung veranschaulicht. Es zeigen:
Fig. 1 eine Stanzeinrichtung in schematisierter, perspektivischer Ansicht,
Fig. 2 die Stanzeinrichtung nach Figur 1, in einer schematisierten, teilweise geschnittenen Seitenansicht,
Fig. 3 die Stanzeinrichtung nach den Figuren 1 und 2, in einer Draufsicht,
Fig. 4 die Stanzeinrichtung nach den Figuren 1 bis 3, in einer ausschnittsweisen Schnittdarstellung, in einem anderen Maßstab,
Fig. 5a die Stanzeinrichtung nach den Figuren 1 bis 4, mit an ihren Stempel angekuppeltem Antrieb, in einer Schnittdarstellung,
Fig. 5b die Stanzeinrichtung nach Figur 5a, beim Abkuppeln der Antriebseinrichtung von dem Stempel, in einer Schnittdarstellung,
Fig. 5c die Stanzeinrichtung nach den Figuren 5a und 5b, mit von dem Stempel abgekuppeltem Antrieb, in einer Schnittdarstellung,
Fig. 6 die Stanzeinrichtung in einer Horizontalschnittdarstellung mit an die Stempel angekuppelten Antriebseinrichtungen, und
Fig. 7 die Stanzeinrichtung nach Figur 6, mit von den Stempeln getrennten Antriebseinrichtungen, in einer Horizontalschnittdarstellung.

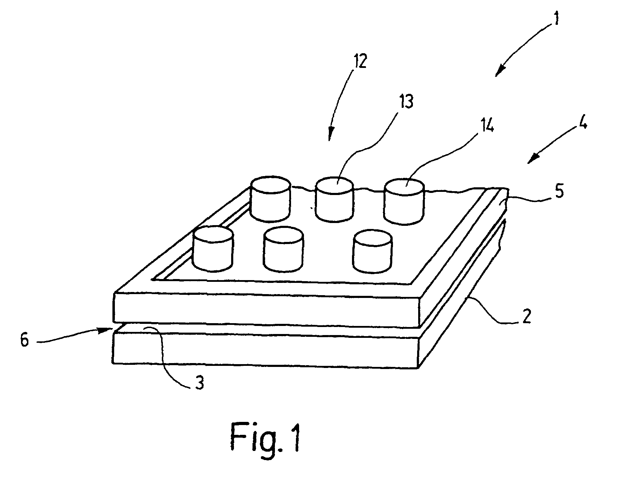

In Figur 1 ist eine Stanzeinrichtung 1 veranschaulicht, mit deren Hilfe ein vorgegebenes oder wählbares Lochmuster in flächenhafte Gebilde, insbesondere ungebrannte Keramikschichten, sogenannte Green Sheets, einzubringen ist, wie sie bei der Herstellung von Keramiksubstraten für elektronische Bauelemente oder Baugruppen Anwendung finden. Zu der Stanzeinrichtung 1 gehören ein Tisch 2, der eine im Wesentlichen plane Oberseite 3 aufweist und dazu dient, das mit Löchern zu versehende Green Sheet aufzunehmen. Mittel zum Positionieren des Green Sheets auf dem Tisch und zum Bewegen bzw. zum Verschieben desselben sind nicht weiter veranschaulicht.

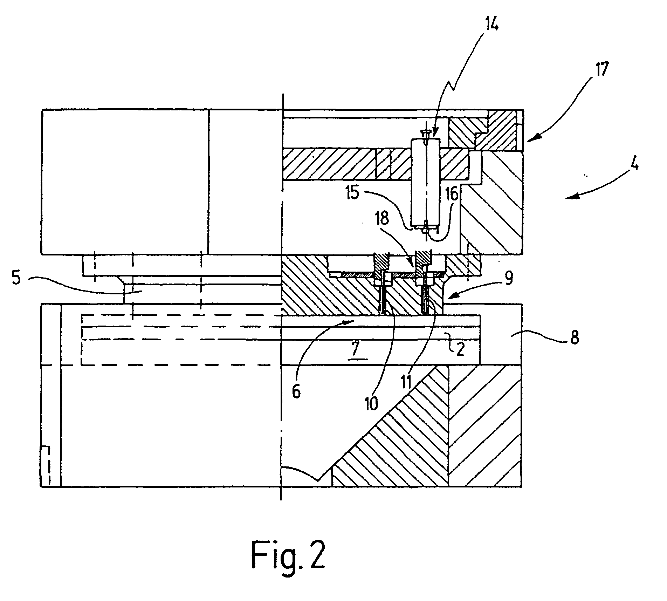

Über dem Tisch 2 ist ein Stanzkopf 4 angeordnet, zu dem ein Grundkörper 5 gehört, der im Wesentlichen flach ausgebildet ist und mit dem Tisch 2 einen Spalt 6 zur Ein- und Durchführung des Green Sheets definiert. Der Grundköper ist mit nicht weiter veranschaulichten Mitteln in einer vorgegebenen Position in Bezug auf den Tisch 2 positioniert. Bedarfsweise kann er so auf den Tisch 2 hin und von diesem weg bewegt werden, dass sich der Spalt 6 verengt oder öffnet. In Betrieb, d.h. insbesondere zur Durchführung von Stanzvorgängen wird der Stanzkopf 4 jedoch nicht bewegt. Dies geht insbesondere aus der etwas weniger schematisierten Darstellung nach Figur 2 hervor. Der Tisch 2, unterhalb dessen ein Aufnahmeraum 7 für Stanzabfälle und eine entsprechende Abführungseinrichtung angeordnet sind, wird von einem Rahmen 8 übergriffen, der an seiner Oberseite eine Öffnung 9 aufweist, in die der Stanzkopf 4 mit einem Teil seines Grundkörpers 5 eintauchen kann.

Zum Stanzen des in den flachen Spalt 6 eingeführten Green Sheets oder sonstigen Flachmaterials, können einzelne, an dem Stanzkopf 4 vorgesehene Stempel 10, 11 sowie weitere nicht weiter veranschaulichte Stempel so bewegt werden, dass sie mit ihrem freien Ende aus dem Grundkörper 5 heraustreten, den Spalt 6 durchqueren und in eine entsprechende gegenüberliegende, in dem Tisch 2 vorgesehene Öffnung eintreten. Die Stempel 10, 11 sind dabei unabhängig voneinander gesondert betätigbar. Zum Antrieb dient eine Antriebseinheit 12, zu der einzelne elektrische Antriebseinrichtungen 13, 14 gehören. Dabei ist vorzugsweise jedem Stempel 10, 11 seine eigene, unabhängig betätigbare Antriebseinrichtung zugeordnet. In Figur 2 ist dies anhand des Stempels 11 und der Antriebseinrichtung 14 symbolisch veranschaulicht.

Die Antriebseinrichtung 14 wird durch einen im Einzelnen nicht weiter veranschaulichten Magnetantrieb oder einen elektrodynamischen Antrieb gebildet, der gezielt separat ansteuerbar ist und bei Betätigung einen an seiner Unterseite 15 herausragenden Schaft 16 um eine Strecke nach unten bewegt. Die Antriebseinrichtung 14 ist, wie die anderen Antriebseinrichtungen auch, über entsprechende Trägerelemente 17 mit dem Grundkörper 5 verbunden und dabei so gehalten, dass der Schaft 16 mit dem Stempel 11 fluchtet.

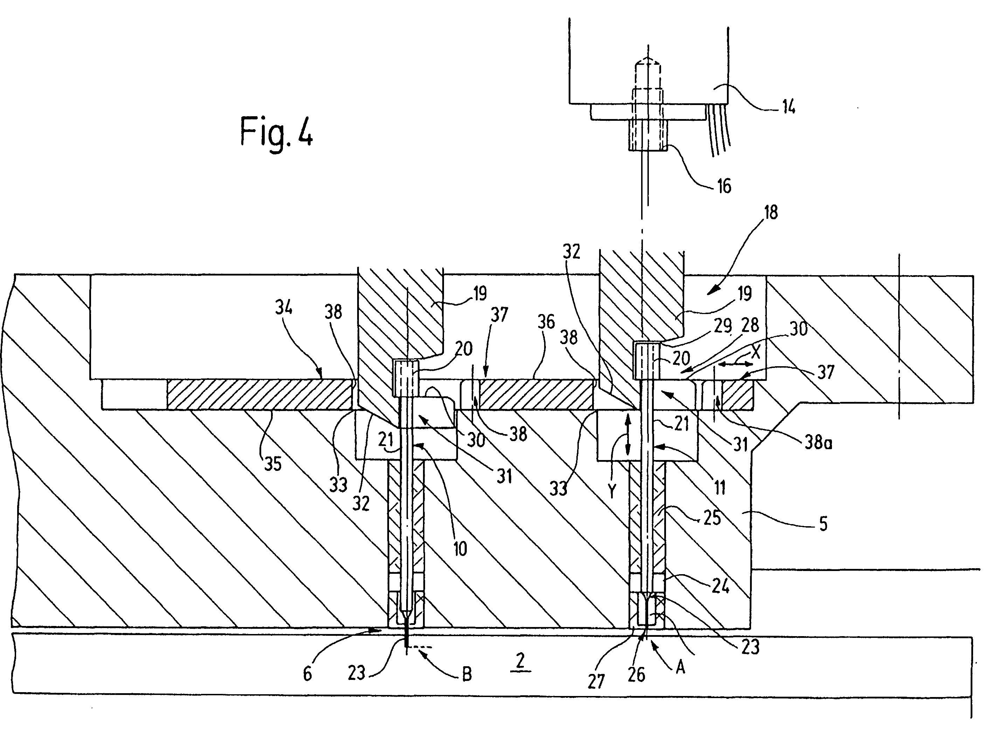

Zur Verbindung des Schafts 16 mit dem Stempel 11 dient eine Kupplungseinrichtung 18, zu der, wie aus Figur 4 hervorgeht, ein Kupplungselement 19 und ein an dem Stempel 11 vorgesehener Kopf 20 gehören. Der Kopf 20 des Stempels 11 wird durch einen zylindrischen Abschnitt gebildet, der einen größeren Durchmesser aufweist als ein sich unmittelbar an den Kopf 20 anschließender zylindrischer Schaftabschnitt 21 des Stempels 11. Dieser geht an seinem in Figur 4 unteren Ende über einen Übergangsbereich 22 in einen zylindrischen Stanzabschnitt 23 über. Der Schaftabschnitt 21 dient der Lagerung und Führung des Stempels 11 an dem Grundkörper 5. Dazu weist dieser eine zu dem Stempel 11 koaxiale Durchgangsbohrung 24 auf, in der eine Führungsbuchse 25 für den Stempel 11 angeordnet ist. Die Führungsbuchse 25 führt den Schaftabschnitt 21 und damit den Stempel 11 spielarm und axial verschiebbar.

Der Stanzabschnitt 23 ragt in eine Durchgangsöffnung 26 eines Führungs- und Abstreifelements 27, das an der Unterseite des Grundkörpers 5 in der Bohrung 24 sitzt. Dabei befindet sich der Stempel 11 in einer Rückzugsposition A, wenn der Stanzabschnitt 23 nicht aus der Öffnung 26 herausragt. Zur Durchführung eines Stanzvorgangs kann der Stempel 11, wie in Figur 4 anhand des Stempels 10 veranschaulicht, axial verschoben werden, so dass der Stanzabschnitt 23 aus der Durchgangsöffnung 26 aus- und nach Durchquerung des Spalts 6 in eine entsprechende in dem Tisch 2 vorgesehene Bohrung eintritt. Der Stempel 10 bzw. 11 nimmt dann seine vorgeschobene Position B (Stanzposition) ein.

Das zu der Kupplungseinrichtung 18 gehörige und von dem Schaft 16 getragene Kupplungselement 19 weist zur Aufnahme des an dem Schaftabschnitt 21 des Stempels 11 angeformten oder auf diesen aufgelöteten zylindrischen Kopfs 20 einen Aufnahmeraum 28 auf, der sich quer zu dem Stempel 11, d.h. in einer Seitenrichtung X öffnet. Der Aufnahmeraum 28 ist dabei bezüglich der Längsrichtung des Stempels 11, die mit seiner Bewegungsrichtung Y übereinstimmt, durch zwei im Abstand parallel zueinander ausgebildete Flächen, nämlich eine Planfläche 29 und eine ebenfalls plane Auflagefläche 30 begrenzt, deren Abstand voneinander nur geringfügig größer ist als die axiale Länge des Kopfs 20. Dieser sitzt somit spielarm in dem Aufnahmeraum 28.

Der den Kopf 20 untergreifende Teil des Kupplungselements 19, an dem die Anlagefläche 30 ausgebildet ist, ist gegabelt ausgebildet oder, mit anderen Worten, mit einer randoffenen Öffnung 31 versehen, durch die sich der Schaftabschnitt 21 des Stempels 11 erstreckt. Die randoffene schlitzartige Öffnung 31 ist in X-Richtung an einer Seite offen. Ihre Weite ist jedoch geringer als der Durchmesser des Kopfs 20, so dass dieser nicht durch die Öffnung 31 rutschen kann.

Um ein Einführen des Kopfs 20 in den Aufnahmeraum 28 zu erleichtern, sind die Planfläche 29 und die Auflagefläche 30 an ihrem in Querrichtung X von dem Kopf 20 abliegenden Ende jeweils mit einer Einführschräge versehen.

Das Kupplungselement 19 ist, wie ebenfalls aus Figur 4 hervorgeht, an seinem von der Antriebseinrichtung 14 abliegenden Ende mit einer als Positionierfläche dienenden Schrägfläche 32 versehen, die im Zusammenwirken mit einer an dem Grundkörper 5 ausgebildeten Kante 33 eine Pösitioniereinrichtung zur Überführung des Kupplungselements 19 in eine obere Position aufweist, in der sich der Stempel 11 in seiner Rückzugsposition A befindet. Die Kante 33 bildet dabei ein Widerlager für die Schrägfläche 32.

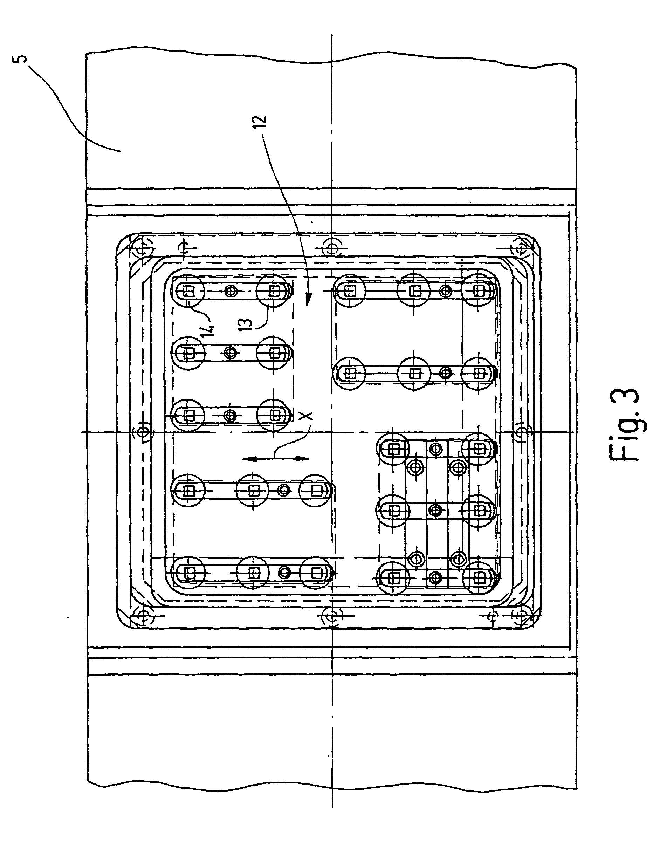

Die Stempel 10, 11 sind, wie alle anderen Stempel auch, untereinander gleich ausgebildet. Ebenso stimmen die zur Führung und Lagerung der Stempel verwendeten Führungsbuchsen 25 und die Führungs- und Abstreifeinrichtungen 27, sowie die Kupplungseinrichtungen 18 und die Antriebseinrichtungen 13, 14 baulich vollständig miteinander überein, so dass die vorstehende Beschreibung des Stempels 11 und der mit ihm zusammenwirkenden Teile und Elemente stellvertretend für die übrigen Stempel und die mit ihnen zusammenwirkenden Teile und Elemente gilt. Die Stempel und Antriebseinrichtungen können gruppenweise angeordnet sein, wie sich aus Figur 3 ergibt. Die gesamte, von allen Antriebseinrichtungen gebildete Antriebseinheit 12 ist so gelagert, dass sie in X-Richtung verschoben werden kann, so dass alle Kupplungselemente 19 mit den entsprechenden Köpfen 20 der ihnen zugeordneten Stempel in und außer Eingriff gelangen. Dabei sollen die Stempel 10, 11 sowie alle übrigen Stempel vorzugsweise in ihre Rückzugsposition A überführt werden bzw. in dieser verbleiben, wenn sie sich in dieser befinden. Insbesondere soll ein ungewolltes Verschieben der Stempel in ihre Stanzposition B bei abgekuppelter Antriebseinheit vermieden werden. Dazu dient eine Kopfplatte 34, die auf einer entsprechenden Gleitfläche 35 des Grundkörpers 5 in X-Richtung verschiebbar angeordnet ist. An ihrer Oberseite 36 weist die Kopfplatte 34 für jeden Stempel einen Auflageflächenbereich 37 auf, der in einer gemeinsamen Ebene mit der Auflagefläche 30 jedes Kupplungselements 19 liegt, wenn sich dieses in einer oberen, die Rückzugsposition A des Stempels 10, 11 festlegenden Position befindet. Die Kopfplatte 34 weist für jeden Stempel 10, 11 einen Durchbruch 38 (Öffnung) auf, durch den das jeweilige Kupplungselement hindurchtreten kann und der an den Auflageflächenbereich 37 grenzt.

An der dem Kupplungselement 19 zugewandten Seite geht der Auflageflächenbereich 37 in eine Einführschräge über. An dem Rand des Durchbruchs 38 ist eine Ausbuchtung 38a ausgebildet, die dazu eingerichtet ist, den Schaftabschnitt 21 des Stempels 10, 11 aufzunehmen, wenn die Kopfplatte 34 unter den jeweiligen Kopf 20 der Stempel 10, 11 geschoben wird. Die Ausbuchtung 38a liegt dem offnen Ende der Öffnung 31 gegenüber und ist praktisch in gerader Verlängerung derselben angeordnet. Zur Aufnahme der Köpfe 20 ist die Kopfplatte 34 in X-Richtung verschiebbar gelagert, wobei der Verschiebeweg so groß ist, dass die Köpfe 20 der Stempel 10, 11 von den Kupplungselementen 19 an die Kopfplatte 34 übergeben werden, wenn die Antriebseinheit 12 gemeinsam mit der Kopfplatte 34 zum Abkuppeln der Antriebseinheit 12 in X-Richtung verschoben wird. Die Kopfplatte 34 ist vorzugsweise mit einer Arretierungseinrichtung verbunden, die ein Verschieben nur gemeinsam mit der Antriebseinheit gestattet. Bei abgenommener Antriebseinheit ist die Kopfplatte dann arretiert.

Die Dicke der Kopfplatte 34 ist vorzugsweise so groß bemessen, wie die Dicke des unter den jeweiligen Kopf 20 greifenden Teils des Kupplungselements, d.h. der Abstand zwischen der Auflagefläche 30 und der auf der anderen Seite des betreffenden gegabelten Teils liegenden Stirnfläche. Dies stellt sicher, dass die Auflagefläche 30 und der Auflageflächenbereich 37 in einer gemeinsamen Ebene liegen, wenn die Antriebseinheit 12 von den Stempeln 10, 11 durch seitliche Verschiebung von den Stempeln 10, 11 abgekuppelt wird. Die Kupplungselemente 19 gelangen dabei in Anlage mit einem sich unmittelbar an die jeweilige Kante 33 des Grundkörpers 5 anschließenden Bereich der Gleitfläche 35, was die Position der Kupplungselemente 19 festlegt.

An der insoweit beschriebenen Stanzeinrichtung 1 erfolgt der Stempelwechsel folgendermaßen:

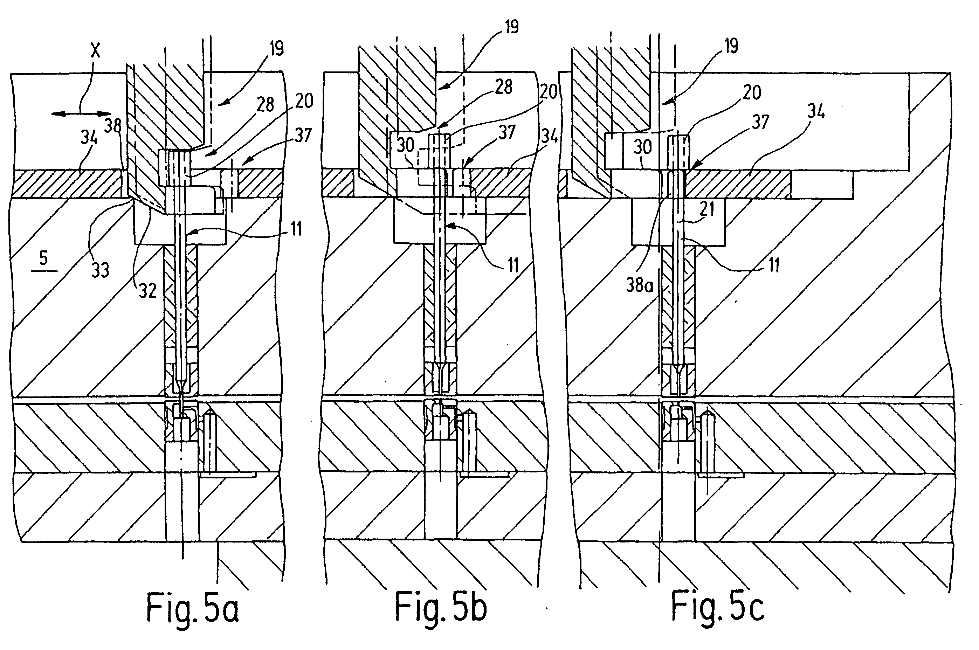

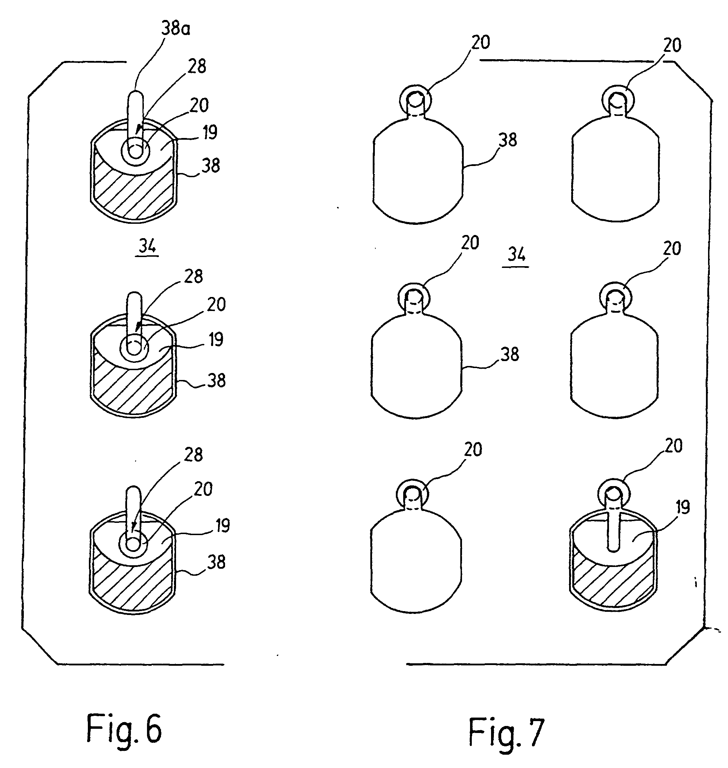

Es wird zunächst davon ausgegangen, dass sich die Stanzeinrichtung 1 in dem in Figur 4 bzw. Figur 6 veranschaulichten Zustand befindet. Alle Antriebseinrichtungen sind mit dem jeweiligen ihnen zugeordneten Stempel verbunden. Die Köpfe 20 der Stempel sind vollständig in die jeweiligen Aufnahmeräume 28 der Kupplungselemente 19 eingetreten. Es wird nun angenommen, dass ein Stempelwechsel erfolgen soll. Wie in Figur 5a anhand des Stempels 11 angedeutet, werden dazu sowohl die Antriebseinheit mit dem zugehörigen Kupplungselement 19, als auch die Kopfplatte 34 so bewegt, dass der Kopf 20 beginnt, seitlich aus dem Aufnahmeraum 28 auszutreten. Wenn sich das Kupplungselement 19 nicht in der der Rückzugsposition A entsprechenden Position befindet, läuft die Schrägfläche 32 an der Kante 33 des Grundkörpers 5 an. Bei der weiteren Bewegung des Kupplungselements 19 in X-Richtung wird, wie bspw. aus Figur 5b hervorgeht, das Kupplungselement 19 zunehmend auf die Antriebseinrichtung hin gedrückt, bis der Stempel 11 in seine Rückzugsposition A gelangt. Dabei gleitet der Kopf 20 aus dem Aufnahmeraum 28 heraus. Infolge des geringen Abstands zwischen den freien Enden der den Kopf 20 untergreifenden Teile des Kupplungselements 19 von dem benachbarten Rand der Durchbruchs 38, der das Kupplungselement 19 umgibt, gleitet der Kopf 20 auf den Auflageflächenbereich 37, bevor er das Kupplungselement 19 ganz verlässt. Der Abstand zwischen dem Rand des Durchbruchs 38 und dem Ende der Auflagefläche 30 ist geringer als der Durchmesser des Kopfs 20. Wenn das Kupplungselement 19 den Kopf 20 ganz freigegeben hat, ist die Kopfplatte 34 unter den Kopf 20 geschoben, so dass der Schaftabschnitt 21 des Stempels 11 in die Ausbuchtung 38a eingetreten ist. Dies ist in Figur 5c in Seitenansicht und in Figur 7 in Draufsicht veranschaulicht. Die Köpfe 20 aller Stempel sind nun von der Kopfplatte 34 getragen. Die Antriebseinrichtungen können einzeln oder gruppenweise abgenommen werden, wodurch die Stempel zugänglich werden. Sie können einzeln oder gruppenweise ausgetauscht werden. Beim Wiederankuppeln der Antriebseinrichtungen, das in umgekehrter Reihenfolge stattfindet, finden alle Kupplungselemente 19 die Köpfe 20 in der richtigen Position vor. Die Köpfe stehen unmittelbar und ohne Höhenversatz neben dem jeweiligen Aufnahmeraum. Das Wiederankuppeln ist problemlos möglich, ohne dass die Köpfe 20 seitlichen Kräften ausgesetzt wären.

Eine Stanzeinrichtung 1, insbesondere zum Stanzen von Löchern oder Lochmustern in Green Sheets, weist Stempel 10, 11 auf, die über Kupplungselemente 19 mit Antriebseinrichtungen 13, 14 verbunden sind. Die Kupplungselemente sind hakenförmige Elemente, die Köpfe 20 der Stempel 10, 11 mit einem gegabelten Abschnitt untergreifen. Den Kupplungselementen 19 ist eine Kopfplatte 34 zugeordnet, die Durchbrüche 38 aufweist, durch die die Kupplungselemente 19 tauchen können. Die Kopfplatte 34 ist etwa auf gleicher Höhe mit dem gegabelten Abschnitt der Kupplungselemente 19 angeordnet, wenn die Stempel 10, 11 in Rückzugsposition befindlich sind. Eine seitliche schlitzartige Ausbuchtung 38a des Durchbruchs 38 liegt dem zwischen den Gabelfingern des Kupplungselements 19 ausgebildeten Schlitz gegenüber, so dass beim Abkuppeln bzw. Ankuppeln der Antriebseinrichtungen von den Stößeln 10, 11 bzw. an die Stößel 10, 11 die Köpfe 20 der Stempel 10, 11 in Rückzugsposition A von den Kupplungselementen 19 an die Kopfplatte 34 bzw. von der Kopfplatte 34 an die Kupplungselemente 19 übergeben werden.

## Patentansprüche

1. Stanzeinrichtung (1), insbesondere zum Stanzen von Löchern in Flachmaterial, insbesondere ungebrannte Keramiksubstrate,
mit einem Grundkörper (5), an dem wenigstens ein Stempel (10, 11) zwischen einer vorgeschobenen und einer zurückgezogenen Position axial verschiebbar gelagert ist,
mit einer Antriebseinheit (12), die an dem Grundkörper (5) lösbar gehalten ist und die wenigstens eine Antriebseinrichtung (13, 14) aufweist, die dem Stempel (10, 11) zugeordnet ist,
wobei jeder Stempel (10, 11) an seinem zu der Antriebseinheit (12) weisenden Ende einen Kopf (20) aufweist, der zum Ankuppeln des Stempels (10, 11) an die Antriebseinrichtung (12) dient,
mit einer Kupplungseinrichtung (18), mittels derer der Stempel (10, 11) jeweils mit der ihm zugeordneten Antriebseinrichtung (13, 14) lösbar verbunden ist, und
wobei die Kupplungseinrichtung (18) ein Kupplungselement (19) aufweist, das dazu eingerichtet ist, den Kopf (20) des Stempels (10, 11) in Axialrichtung des Stempels (10, 11) spielarm oder spielfrei aufzunehmen, um mit dem Kopf (20) die Kupplungseinrichtung (18) zu bilden,
**gekennzeichnet durch**
eine Aufnahmeeinrichtung (34), die **durch** eine an dem Grundkörper (5) angeordnete Kopfplatte gebildet ist, die quer zu den Stempeln (10, 11) verschiebbar gelagert ist und die Öffnungen (38) aufweist, **durch** die die Kupplungselemente (19) hindurchtreten können, um die Stempel (10, 11) in einer gewünschten Axialposition zu halten, wenn die Antriebseinheit (12) von dem Stößel (10, 11) getrennt ist.

2. Stanzeinrichtung nach Anspruch 1, **dadurch gekennzeichnet, dass** an dem Grundkörper (5) mehrere untereinander vorzugsweise im Wesentlichen gleich ausgebildete Stempel (10, 11) voneinander unabhängig axial und parallel zueinander verschiebbar gelagert sind.

3. Stanzeinrichtung nach Anspruch 1, **dadurch gekennzeichnet, dass** die Stempel (10, 11) jeweils einen zylindrischen Schaftabschnitt (21) und einen sich an diesen über einen Übergangsbereich (22) anschließenden zylindrischen Stanzabschnitt (23) aufweist, dessen Durchmesser geringer ist als der Durchmesser des Schaftabschnitts (21) und der vorzugsweise separat in einem Führungs- und Abstreifelement (27) gelagert ist, und dass an dem Grundkörper (5) zur Führung der Stempel (10, 11) vorzugsweise durch Führungsbuchsen (25) gebildete Stempelführungen vorgesehen sind, aus denen die Stempel (10, 11) bedarfsweise axial herausziehbar sind.

4. Stanzeinrichtung nach Anspruch 1, **dadurch gekennzeichnet, dass** das Kupplungselement (19) einen seitlich offenen Aufnahmeraum (28) für den Kopf (20) aufweist.

5. Stanzeinrichtung nach Anspruch 1, **dadurch gekennzeichnet, dass** das Kupplungselement (19) eine im Wesentlichen plane Auflagefläche (30) aufweist, die im Wesentlichen quer zu dem Stempel (10, 11) ausgerichtet und von einer randoffenen, vorzugsweise schlitzartigen Öffnung (31) durchsetzt ist.

6. Stanzeinrichtung nach Anspruch 1, **dadurch gekennzeichnet, dass** das Kupplungselement (19) mit der Antriebseinrichtung (13, 14) fest verbunden und mit dieser gemeinsam zum Abkuppeln des Stempels (10, 11) quer zu dem Stempel (10, 11) in einer Richtung (X) verschiebbar gelagert ist, die mit einer von dem Kupplungselement (19) festgelegten Abkuppelrichtung übereinstimmt.

7. Stanzeinrichtung nach Anspruch 5, **dadurch gekennzeichnet, dass** die Kopfplatte mit ihrer Oberseite (36) auf einer Höhe mit der Auflagefläche (30) des Kupplungselements (19) angeordnet ist, wenn der Stempel (10, 11) in seine zurückgezogene Position überführt ist.

8. Stanzeinrichtung nach Anspruch 1, **dadurch gekennzeichnet, dass** die Kopfplatte für jeden Stempel (10, 11) eine Einrichtung zur Aufnahme und Fixierung des Stempels (10, 11) aufweist, wenn dieser von der Antriebseinrichtung (12) getrennt ist.

9. Stanzeinrichtung nach Anspruch 8, **dadurch gekennzeichnet, dass** die Einrichtung zur Aufnahme und Fixierung des Stempels (10, 11) durch einen an der Oberseite (36) der Kopfplatte vorgesehenen Auflageflächenbereich (37) gebildet ist, der von einer randoffenen Öffnung (38a) durchsetzt ist und der dazu dient, den Kopf (20) des Stempels (10, 11) aufzunehmen.

10. Stanzeinrichtung nach Anspruch 1, **dadurch gekennzeichnet, dass** die Kopfplatte an ihrer der Oberseite (36) gegenüberliegenden Seite eine Lagerfläche aufweist, die vorzugsweise auf einer Höhe mit einer Stirnfläche liegt, die an dem Kupplungselement (19) an der von der Antriebseinrichtung (13, 14) abliegenden Seite ausgebildet ist.

11. Stanzeinrichtung nach Anspruch 10, **dadurch gekennzeichnet, dass** an dem Kupplungselement (19) im Anschluss an die Stirnfläche eine Positionierfläche (32) ausgebildet ist, die dazu eingerichtet ist, das Kupplungselement (19) in eine Position zu überführen, die die rückgezogene Position des Stempels (10, 11) festlegt.

12. Stanzeinrichtung nach Anspruch 11, **dadurch gekennzeichnet, dass** die Positionierfläche (32) durch eine schräge Anlauffläche gebildet ist.

13. Stanzeinrichtung nach Anspruch 11, **dadurch gekennzeichnet, dass** der Positionierfläche (32) ein vorzugweise an dem Grundkörper (5) ausgebildetes Widerlager zugeordnet ist.

14. Stanzeinrichtung nach Anspruch 13, **dadurch gekennzeichnet, dass** das Widerlager durch eine ortsfeste, an dem Grundkörper (5) ausgebildete Kante (33) gebildet ist.

15. Stanzeinrichtung nach Anspruch 1, **dadurch gekennzeichnet, dass** die Antriebseinheit (12) und die Kopfplatte (34) gemeinsam quer zu dem Stempel (10, 11) verschiebbar angeordnet sind.

16. Stanzeinrichtung nach Anspruch 2, **dadurch gekennzeichnet, dass** jedem Stempel (10, 11) eine Antriebseinrichtung (13, 14) zugeordnet ist, dass die Antriebseinrichtungen (13, 14) jeweils über eine Kupplungseinrichtung (18) mit dem ihnen zugeordneten Stempel (10, 11) verbunden sind, dass die Kupplungs- und Entkupplungsrichtungen der Kupplungseinrichtungen (18) wenigstens gruppenweise miteinander übereinstimmen und dass die Antriebseinrichtungen (13, 14) einzeln oder gruppenweise abnehmbar sind, so dass die Stempel (10, 11) zugänglich sind.

17. Stanzeinrichtung nach Anspruch 1, **dadurch gekennzeichnet, dass** die Antriebseinrichtung (13, 14) eine elektrische oder elektromagnetische Antriebseinrichtung ist.

## Claims

1. Punching device (1), in particular for punching holes in flat material, in particular unfired ceramic substrates,
with a base body (5), on which at least one die (10, 11) is disposed to be axially displaceable between an advanced position and a retracted position,
with a drive unit (12), which is detachably held on the base body (5) and which has at least one drive means (13, 14) assigned to the die (10, 11),
wherein at its end pointing towards the drive unit (12), each die (10, 11) has a head (20), which serves to couple the die (10, 11) to the drive means (12),
with a coupling means (18), by means of which the die (10, 11) is respectively detachably connected to the drive means (13, 14) assigned to it, and
wherein the coupling means (18) has a coupling element (19), which is fitted to receive the head (20) of the die (10, 11) in the axial direction of the die (10, 11) with low play or free from play in order to form the coupling means (18) together with the head (20),
**characterised by**
a receiving means (34), which is formed by a head plate arranged on the base body (5), said head plate being disposed to be displaceable transversely to the dies (10, 11) and having openings (38), through which the coupling elements (19) can pass in order to hold the dies (10, 11) in a desired axial position when the drive unit (12) is separated from the ram (10, 11).

2. Punching device according to Claim 1, **characterised in that** several dies (10, 11) preferably with essentially the same configuration are disposed to be displaceable independently of one another axially and parallel to one another.

3. Punching device according to Claim 1, **characterised in that** the dies (10, 11) respectively have a cylindrical shaft section (21) and a cylindrical punching section (23), which adjoins this via a transition area (22) and the diameter of which is smaller than the diameter of the shaft section (21), and which is preferably disposed separately in a guide and stripping element (27), and that provided on the base body (5) for guidance of the dies (10, 11) are die guides, which are preferably formed by guide bushes (25) and from which the dies (10, 11) can be pulled out axially, as required.

4. Punching device according to Claim 1, **characterised in that** the coupling element (19) has a laterally open receiving area (28) for the head (20).

5. Punching device according to Claim 1, **characterised in that** the coupling element (19) has an essentially plane supporting surface (30), which is oriented essentially transversely to the die (10, 11) and has a preferably slot-like opening (31) open at the edge passing through it.

6. Punching device according to Claim 1, **characterised in that** the coupling element (19) is firmly connected to the drive means (13, 14), and to decouple the die (10, 11) is disposed jointly with this to be displaceable transversely to the die (10, 11) in a direction (X), which is the same as a decoupling direction defined by the coupling element (19).

7. Punching device according to Claim 5, **characterised in that** the head plate is arranged with its upper side (36) on a level with the supporting surface (30) of the coupling element (19) when the die (10, 11) is moved into its retracted position.

8. Punching device according to Claim 1, **characterised in that** for each die (10, 11) the head plate has a means for receiving and fastening the die (10, 11) when this is separated from the drive means (12).

9. Punching device according to Claim 8, **characterised in that** the means for receiving and fastening the die (10, 11) is formed by a supporting surface region (37), which is provided on the upper side (36) of the head plate, has an opening (38a) open at the edge passing through it and serves to receive the head (20) of the die (10, 11).

10. Punching device according to Claim 1, **characterised in that** on its side opposite the upper side (36), the head plate has a bearing surface, which preferably lies on a level with an end face, which is configured on the coupling element (19) on the side remote from the drive means (13, 14).

11. Punching device according to Claim 10, **characterised in that** adjoining the end face on the coupling element (19) a positioning surface is configured, which is fitted to move the coupling element (19) into a position, which defines the retracted position of the die (10, 11).

12. Punching device according to Claim 11, **characterised in that** the positioning surface (32) is formed by an inclined stop face.

13. Punching device according to Claim 11, **characterised in that** the positioning surface (32) has an associated abutment preferably configured on the base body (5).

14. Punching device according to Claim 13, **characterised in that** the abutment is formed by a fixed edge (33) configured on the base body (5).

15. Punching device according to Claim 1, **characterised in that** the drive unit (12) and the head plate (34) are arranged to be displaceable jointly transversely to the die (10, 11).

16. Punching device according to Claim 2, **characterised in that** a drive means (13, 14) is assigned to each die (10, 11), that the drive means (13, 14) are respectively connected to their assigned die (10, 11) via a coupling means (18), that the coupling and decoupling directions of the coupling means (18) are the same as one another at least in groups, and that the drive means (13, 14) can be removed singly or in groups so that the dies (10, 11) are accessible.

17. Punching device according to Claim 1, **characterised in that** the drive means (13, 14) is an electric or electromagnetic drive means.

## Revendications

1. Dispositif de poinçonnage (1), notamment pour le découpage de trous dans des produits plats, notamment dans des substrats céramiques non cuits, comportant
un corps de base (5) dans lequel au moins un poinçon (10, 11) est monté avec possibilité de coulissement dans la direction axiale entre une position sortie et une position rentrée,
une unité d'entraînement (12), qui est fixée de manière séparable au corps de base (5) et présente au moins un dispositif d'entraînement (13, 14) associé au poinçon (10, 11),
chaque poinçon (10, 11) étant pourvu à son extrémité tournée vers l'unité d'entraînement (12) d'une tête (20), qui sert à l'accouplement du poinçon (10, 11) avec le dispositif d'entraînement (12),
un dispositif d'accouplement (18) par l'intermédiaire duquel le poinçon (10, 11) est lié de manière séparable au dispositif d'entraînement (13, 14)) qui lui est associé, et
le dispositif d'accouplement (18) comprenant un élément d'accouplement (19) agencé pour recevoir la tête (20) du poinçon (10, 11) avec un faible jeu ou sans jeu dans la direction axiale du poinçon (10, 11), pour former avec la tête (20) le dispositif d'accouplement (18),
**caractérisé par** un dispositif d'arrêt (34) qui est constitué d'une plaque porte-nez montée avec possibilité de coulissement transversalement aux poinçons (10, 11) et pourvue d'ouvertures (38) au travers desquelles passent les éléments d'accouplement (39) aux fins de retenir les poinçons (10, 11) dans une position axiale souhaitée, lorsque l'unité d'entraînement (12) est séparée des poinçons (10, 11).

2. Dispositif selon la revendication 1, **caractérisé par le fait que** plusieurs poinçons (10, 11), de préférence essentiellement identiques entre eux, sont montés sur le corps de base (5) avec possibilité de coulissement indépendamment l'un de l'autre et parallèlement l'un à l'autre dans la direction axiale.

3. Dispositif selon la revendication 1, **caractérisé par le fait que** le poinçon (10, 11) présente chaque fois une portion queue (21) cylindrique et une portion poinçon (23) cylindrique qui se raccorde à la première par une zone de transition (22), dont le diamètre est inférieur au diamètre de la portion queue (21) et qui de préférence est montée séparément dans un élément guide et dévêtisseur (27) et **par le fait que** qu'il est prévu sur le corps de base (5), pour le guidage du poinçon (10, 11) des guides de poinçon conformés de préférence en douilles de guidage (25), hors desquelles les poinçons peuvent être extraits axialement en cas de besoin.

4. Dispositif de poinçonnage selon la revendication 1, **caractérisé par le fait que** l'élément d'accouplement (19) présente une chambre réceptrice (28) ouverte latéralement pour la tête (20).

5. Dispositif de poinçonnage selon la revendication 1, **caractérisé par le fait que** l'élément d'accouplement (19) présente une surface d'appui (30) essentiellement plane, qui est orientée essentiellement transversalement au poinçon (10, 11) et est traversée par ouverture (31) de préférence en forme de fente ouverte côté bord.

6. Dispositif de poinçonnage selon la revendication 1, **caractérisé par le fait que** l'élément d'accouplement (19) est solidaire du dispositif d'entraînement (13, 14) et, pour le désaccouplement du poinçon (10, 1 1 ), peut coulisser avec celui-ci transversalement au poinçon (10, 11), dans une direction (X) qui correspond à une direction de désaccouplement définie par l'élément d'accouplement (19).

7. Dispositif de poinçonnage selon la revendication 1, **caractérisé par le fait que** la face supérieure (36) de la plaque porte-nez est située à la hauteur de la surface d'appui de l'élément d'accouplement (19), lorsque le poinçon (10, 11) est amené dans sa position rentrée.

8. Dispositif de poinçonnage selon la revendication 1, **caractérisé par le fait que** la plaque porte-nez, pour chaque poinçon (10, 11), présente un dispositif pour recevoir et retenir le poinçon (10, 11), lorsque celui-ci est séparé du dispositif d'entraînement (12).

9. Dispositif de poinçonnage selon la revendication 8, **caractérisé par le fait que** le dispositif pour recevoir et retenir le poinçon (10, 11) est formé par une zone de surface d'appui (37) sur la face supérieure (36) de la plaque porte-nez qui est traversée par une ouverture (38a) ouverte côté bord et est destinée à recevoir la tête (20) du poinçon (10, 11).

10. Dispositif de poinçonnage selon la revendication 1, **caractérisé par le fait que** la plaque porte-nez, sur sa face en vis-à-vis de la face supérieure (36), présente une surface de palier qui, de préférence, est située à la même hauteur qu'une surface frontale aménagée sur la face de l'élément d'accouplement (19) éloignée du dispositif d'entraînement (13, 14).

11. Dispositif de poinçonnage selon la revendication 10, **caractérisé par le fait que** sur l'élément d'accouplement (19), à la suite de la surface frontale, est aménagée une surface de positionnement (32) qui est conformée de manière à amener l'élément d'accouplement (19) dans une position qui définit la position rentrée du poinçon (10, 11).

12. Dispositif de poinçonnage selon la revendication 11, **caractérisé par le fait que** la surface de positionnement (32) est formée d'une surface d'approche inclinée.

13. Dispositif de poinçonnage selon la revendication 11, **caractérisé par le fait qu'**à la surface de positionnement (32) est associé un contre-appui aménagé de préférence sur le corps de base (5).

14. Dispositif de poinçonnage selon la revendication 13, **caractérisé par le fait que** le contre-appui est formé par une arête (33) aménagée sur le corps de base (5).

15. Dispositif de poinçonnage selon la revendication 1, **caractérisé par le fait que** l'unité d'entraînement (12) et la plaque porte-nez (34) sont disposées toutes deux avec possibilité de déplacement transversalement au poinçon (10, 11).

16. Dispositif de poinçonnage selon la revendication 2, **caractérisé par le fait qu'**à chaque poinçon (10, 11) est associé un dispositif d'entraînement (13, 14), **par le fait que** les dispositifs d'entraînement (13, 14) sont liés chaque fois par un dispositif d'accouplement (18) au poinçon (10, 11) associé, **par le fait que** les directions d'accouplement et de désaccouplement des dispositifs d'accouplement (18) concordent entre elles au moins par groupes et **par le fait que** les dispositifs d'entraînement (13, 14) peuvent être retirés séparément ou par groupes de telle sorte que les poinçons (10, 11) soient accessibles.

17. Dispositif de poinçonnage selon la revendication 1, **caractérisé par le fait que** le dispositif d'entraînement (13, 14) est un dispositif d'entraînement électrique ou électromagnétique.
